# EUROPÄISCHE PATENTANMELDUNG

(11) **EP 1 293 789 A1**
(43) Veröffentlichungstag der Anmeldung: **19.03.2003**
(21) Anmeldenummer: 01440297.8
(22) Anmeldetag: 12.09.2001
(51) Int. Cl.: G01R 31/317

(54) **Verfahren zum Testen und Inbetriebnehmen einer elektrischen Schaltungseinheit sowie solche Schaltunseinheiten**

(71) Anmelder: ALCATEL, 75008 Paris (FR)
(72) Erfinder: Friedrich, Carsten, 71634 Ludwigsburg (DE)
(74) Vertreter: Brose, Gerhard

(57) **Zusammenfassung**

Die Erfindung betrifft ein Verfahren zum Testen und Inbetriebnehmen einer elektrischen Schaltungseinheit (integrierte Schaltung, Modul, Gerät, CU), bei welchem Verfahren über eine dafür vorgesehene elektrische Testschnittstelle (IF3) Testsignale ausgetauscht werden zwischen der Umgebung der Schaltungseinheit (CU) und einer in der Schaltungseinheit (CU) mit enthaltenen Testschaltungseinheit (TU), bei welchem Verfahren durch die Testschaltungseinheit (TU) innerhalb der Schaltungseinheit (CU) Tests durchgeführt werden, die durch Testsignale von außen eingeleitet und deren Ergebnisse über Testsignale nach außen gemeldet werden, bei dem am Ende der Tests eine Umkonfigurierung der Testschaltungseinheit (TU) durchgeführt wird, derart, daß die zunächst für die Testschaltungseinheit (TU) benötigten Schaltungsteile nach der anschließenden Inbetriebnahme normale Betriebsaufgaben der Schaltungseinheit (CU) wahrnehmen, sowie solche Schaltungseinheiten (CU).

## Beschreibung

Die Erfindung betrifft ein Verfahren zum Testen und Inbetriebnehmen einer elektrischen Schaltungseinheit nach dem Oberbegriff des Anspruchs 1, eine elektrische Schaltungseinheit (integrierte Schaltung, Modul, Gerät), mit einer in der Schaltungseinheit enthaltenen Testschaltungseinheit und einer elektrischen Testschnittstelle nach dem Oberbegriff des Anspruchs 2 und eine elektrische Schaltungseinheit (integrierte Schaltung, Modul, Gerät), die zumindest teilweise als elektrisch umkonfigurierbare Schaltung ausgeführt ist nach dem Oberbegriff des Anspruchs 3.

Daß eine neu gefertigte Schaltung vor ihrer Inbetriebnahme auch geprüft (getestet) wird, kann schon als Selbstverständlichkeit angesehen werden. Auch daß in der industriellen Fertigung auch die Tests automatisiert werden, ist längst bekannt. Abgesehen von Teststifts, "probes", mit denen Testsignale zugeführt oder Testergebnisse abgegriffen werden können, ist auch die Verwendung integrierter Testschaltungen längst bekannt. Der Begriff "integriert" wird hier nicht im Sinne einer bestimmten Technologie verstanden, sondern so, daß eine solche integrierte Testschaltung integraler Bestandteil der jeweiligen Schaltung ist und mit ihr zusammen gefertigt wird und auch nach den Tests mit ihr verbunden bleibt.

Das bisher Gesagte ist unabhängig davon, oh die "Schaltung" nun eine integrierte Schaltung im heutigen engeren Sinn ist oder ein Modul mit möglicherweise mehreren integrierten Schaltungen oder auch ein größeres Gerät, das wiederum möglicherweise aus mehreren Modulen besteht. All dies soll unter dem hier verwendeten künstlichen Oberbegriff "elektrische Schaltungseinheit" verstanden werden. Auch die Testschaltung ist, wie die Schaltungseinheit selbst, unter Umständen hierarchisch aufgebaut und kann beim größeren Gerät durchaus ein komplettes Testmodul, in jedem Einzelmodul eine integrierte Schaltung als Testschaltung und in jeder einzelnen integrierten Schaltung eine "Testecke" umfassen. Zwangsläufig sind dann auch geeignete Signalwege einerseits zwischen diesen Testschaltungen und andererseits von den Testschaltungen ausgehend durch die zu testenden Schaltungsteile hindurch und wieder zurück zu den Testschaltungen vorhanden. Außerdem ist zwingend eine Möglichkeit vorhanden, um die Tests durch Testsignale von außen einzuleiten und deren Ergebnisse über Testsignale nach außen zu melden. Für solche komplexen Anordnungen gibt es eine Norm der IEEE, die IEEE 1149.1, "IEEE Standard Test Access Port and Boundary Scan Architecture", sowie darauf aufbauende Normen für näher konkretisierte Anwendungsfälle.

Es ist zwar grundsätzlich möglich, über solche integrierten Testschaltungen auch später im Betrieb gelegentlich Tests durchzuführen. In der Regel ist dies aber nicht vorgesehen. Dann bilden diese Testschaltungen einen unnötigen Ballast, der nur Platz wegnimmt und möglicherweise, weil nicht vollständig abschaltbar, sogar noch unnötig Energie verbraucht und entsprechende Wärme erzeugt.

Der Erfindung liegt die Aufgabe zugrunde, eine Möglichkeit zu schaffen, um einerseits zu Beginn die erforderlichen Tests durchführen zu können und dennoch andererseits den Ballast einer Testschaltung nicht laufend mitschleppen zu müssen.

Diese Aufgabe wird erfindungsgemäß gelöst durch ein Verfahren nach der Lehre des Anspruchs 1, eine elektrische Schaltungseinheit nach der Lehre des Anspruchs 2 und eine elektrische Schaltungseinheit nach der Lehre des Anspruchs 3.

Der Grundgedanke der Erfindung liegt darin, zumindest einen Teil einer Schaltungseinheit umkonfigurierbar auszuführen und diesen Teil zunächst als Testschaltung und später, nach Umkonfigurierung, zusammen mit dem Rest der Schaltungseinheit für deren normalen Betrieb zu verwenden.

Weitere Ausgestaltungen der Erfindung sind den Unteransprüchen und der nachfolgenden Beschreibung zu entnehmen.

Im folgenden wird die Erfindung unter Zuhilfenahme der beiliegenden Zeichnungen weiter erläutert:

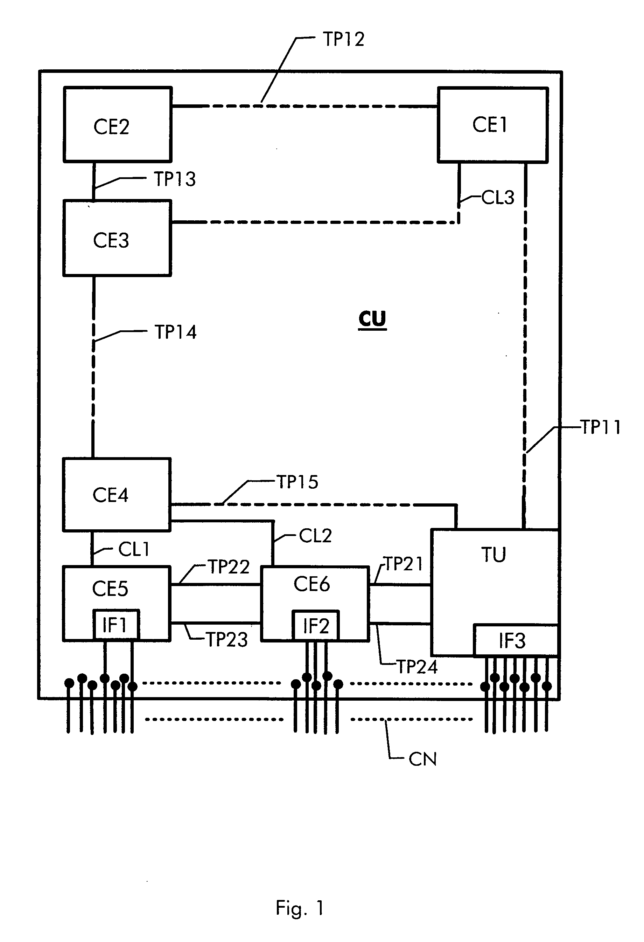

- Figur 1: zeigt ein Ausführungsbeispiel einer erfindungsgemäßen Schaltungseinheit, in dem das erfindungsgemäße Verfahren durchgeführt werden kann.

Anhand der Figur 1 wird zunächst ein beispielhafter Aufbau einer erfindungsgemäßen Schaltungseinheit beschrieben.

Figur 1 zeigt eine als steckbare Schaltungsplatine dargestellte Schaltungseinheit CU. Sie weist mehrere einzelne Schaltungselemente auf, von denen die Schaltungselemente CE1, ... , CE6 eingezeichnet sind. Weiter ist eine Testschaltungseinheit TU eingezeichnet. Bei den Schaltungselementen CE5 und CE6 und bei der Testschaltungseinheit TU sind Schnittstellenschaltungen IF1, IF2 bzw. IF3 dargestellt. Weiter ist am unteren Rand eine Steckerleiste CN durch einzelne ihrer Steckerstifte angedeutet. Es sind auch einzelne Verbindungen zwischen den Schnittstellenschaltungen IF1, IF2 und IF3 einerseits und einzelnen Steckerstiften der Steckerleiste CN andererseits dargestellt. Innerhalb der Schaltungseinheit CU sind zwei von der Testschaltungseinheit TU ausgehende und wieder zu ihr zurückführende Testwege TP1 und TP2 durch die Testwegeabschnitte TP11, ... , TP15 bzw. TP21, ... , TP24 dargestellt. Weiter sind beispielhaft drei Verbindungsleitungen CL1, CL2 und CL3 als Verbindungen zwischen je zwei Schaltungselementen, hier den Schaltungselementpaaren CE4-CE5, CE4-CE6 und CE1-CE3, eingezeichnet.

Eine solche Schaltungsplatine kann als Modul einer größeren Schaltung angesehen werden. Durch andere zeichnerische Darstellung (Weglassung des Rands und der Steckerleiste) und andere Benennung der Teile (Schaltungselement als Schaltungsplatine) wird daraus ein komplettes Gerät, durch andere Interpretation eine integrierte Schaltung im engeren Sinn.

Wird in Figur 1 die Testschaltungseinheit TU ebenfalls als Schaltungselement bezeichnet und werden die Testwegeabschnitte TP11, ... , TP15 bzw. TP21, ... , TP24 als Verbindungsleitungen bezeichnet, so ergibt sich ebenfalls eine weitere Ausführungsform der Erfindung. Die Ausführungsform nach Figur 1 und die zuletzt angedeutete Ausführungsform stellen die beiden Varianten ein und derselben Schaltungseinheit dar, wie sie sich vor und nach dem Umkonfigurieren der anfänglichen Testschaltungseinheit ergeben.

In der Schaltungseinheit CU nach Figur 1 ist eine Testkonfiguration mit (hier zwei) Testschleifen vorgesehen, wie sie beispielsweise in der eingangs erwähnten Norm vorgesehen ist. Die von der Testschaltungseinheit TU ausgehenden und wieder sich dort schließenden Testschleifen, hier die Testwege TP1 und TP2 und etwaige weitere, nicht eingezeichnete, verbinden alle zu testenden Schaltungselemente mit der Testschaltungseinheit TU. Von dieser aus können dann verschiedene Tests in den einzelnen Schaltungselementen initiiert und die Ergebnisse dieser Tests an die Testschaltungseinheit TU zurückgemeldet werden. Diese Tests können über die Schnittstelle IF3 von außen angestoßen oder gesteuert werden; die Ergebnisse können über diese Schnittstelle nach außen gemeldet werden.

Eine auch häufig vorkommende Testkonfiguration sieht vor, in einem Testgenerator ein Testsignal zu generieren und dies an geeigneter Stelle anstelle eines später im Betrieb vorkommenden Signals in einen Signalweg einzuspeisen und an einer anderen Stelle des Signalwegs das resultierende Signal wieder auszukoppeln und einem Testempfänger zuzuführen. Die Testschaltungseinheit TU könnte auch im wesentlichen aus mindestens einem solchen Testgenerator und mindestens einem Testempfänger bestehen. Die Testwege fielen dann weitgehend mit den Signalwegen des normalen Betriebs zusammen.

Die Testschaltungseinheit TU ist nun so ausgeführt, daß sie von außen, hier über die Schnittstelle IF3, nach Beendigung der Tests, vielleicht später auch nochmals, umkonfiguriert werden kann. Die Umkonfiguration kann natürlich auch über andere Wege erfolgen, etwa über eine zusätzliche Schnittstelle, die in die Testschaltungseinheit TU integriert ist, möglicherweise zusammen mit der bereits vorhandenen Schnittstelle IF3.

Dies ist beispielsweise dadurch möglich, daß die Testschaltungseinheit TU als sogenanntes "FPGA" (Field Programmable Gate Array) ausgeführt ist. Solche FPGAs sind an sich allgemein bekannt. Sie weisen eine Vielzahl logischer Gatter auf, deren Verbindungen untereinander programmierbar sind. Damit wird dann insgesamt eine konkrete Logik aufgebaut.

Eine andere Möglichkeit einer Umkonfigurierbarkeit der Testschaltungseinheit TU ist dann gegeben, wenn diese unter anderem einen Mikroprozessor und einen Programmspeicher aufweist und der Programmspeicher zunächst ein Programm enthält, mit dessen Hilfe der Mikroprozessor die Schaltungseinheit CU testet. Anschließend kann dann in den Programmspeicher über die Schnittstelle IF3 ein Programm eingeschrieben werden, mit dessen Hilfe dann der spätere Betrieb der Schaltungseinheit CU durchgeführt wird.

Derjenige Teil der Schaltungseinheit CU, der sich erst durch Umkonfiguration der Testschaltungseinheit Tu nach den Tests ergibt, kann natürlich durch die Tests vor der Umkonfigurierung nicht mit geprüft werden. Zumindest die Komponenten der Testschaltungseinheit Tu, wie Speicher, Prozessoren und Logikgatter, bleiben aber bei der Umkonfiguration unverändert und können somit getestet werden. Nur die Verbindungen der Komponenten untereinander sowie die Inhalte der Speicher werden geändert und können deshalb möglicherweise fehlerhaft sein. Was die Inhalte der Speicher betrifft, so dürfte es kein Problem sein, diese zur Kontrolle auszulesen. Hinsichtlich der Umkonfiguration der Verbindungen zwischen Gattern könnte daran gedacht werden, diese derart schrittweise durchzuführen, daß die bereits umkonfigurierten Schaltungsteile durch die noch nicht umkonfigurierten Schaltungsteile in ihrer neuen Funktion geprüft werden.

Selbstverständlich muß bei der Konzeption der gesamten Schaltung berücksichtigt werden, daß diejenigen Verbindungsleitungen, die zunächst als Testwegeabschnitte benötigt werden, ebenso wie die zugehörigen Ausgänge und Eingänge der Schaltungselemente auch nach der Umkonfiguration unverändert sind. Dies kann beispielsweise dadurch erreicht werden, daß als Testwegeabschnitte solche Verbindungsleitungen verwendet werden, die im späteren Betrieb ohnehin erforderlich sind. Eine andere Möglichkeit liegt darin, die einzelnen Schaltungselemente auf verschiedene Betriebsarten umschaltbar einzurichten, wobei dann eine Betriebsart der Testbetrieb ist.

## Patentansprüche

1. Verfahren zum Testen und Inbetriebnehmen einer elektrischen Schaltungseinheit (integrierte Schaltung, Modul, Gerät, CU), bei welchem Verfahren über eine dafür vorgesehene elektrische Testschnittstelle (IF3) Testsignale ausgetauscht werden zwischen der Umgebung der Schaltungseinheit (CU) und einer in der Schaltungseinheit (CU) mit enthaltenen Testschaltungseinheit (TU), bei welchem Verfahren durch die Testschaltungseinheit (TU) innerhalb der Schaltungseinheit (CU) Tests durchgeführt werden, die durch Testsignale von außen eingeleitet und deren Ergebnisse über Testsignale nach außen gemeldet werden, **dadurch gekennzeichnet, daß** am Ende der Tests eine Umkonfigurierung der Testschaltungseinheit (TU) durchgeführt wird, derart, daß die zunächst für die Testschaltungseinheit (TU) benötigten Schaltungsteile nach der anschließenden Inbetriebnahme normale Betriebsaufgaben der Schaltungseinheit (CU) wahrnehmen.

2. Elektrische Schaltungseinheit (integrierte Schaltung, Modul, Gerät, CU), mit einer in der Schaltungseinheit (CU) enthaltenen Testschaltungseinheit (TU) und einer elektrischen Testschnittstelle (IF3), die so ausgebildet ist, daß über sie Testsignale ausgetauscht werden können zwischen der Umgebung der Schaltungseinheit (CU) und der in der Schaltungseinheit (CU) mit enthaltenen Testschaltungseinheit (TU), bei welcher Schaltungseinheit (CU) die Testschaltungseinheit (TU) so ausgebildet ist, daß durch sie innerhalb der Schaltungseinheit (CU) Tests durchgeführt werden können, die durch Testsignale von außen eingeleitet und deren Ergebnisse über Testsignale nach außen gemeldet werden können, **dadurch gekennzeichnet, daß** die Testschaltungseinheit (TU) als elektrisch umkonfigurierbare Schaltung ausgeführt ist und daß die Schaltungseinheit (CU) so ausgebildet ist, daß am Ende der Tests eine Umkonfigurierung der Testschaltungseinheit (TU) derart möglich ist, daß die zunächst als Testschaltungseinheit (TU) vorgesehenen Schaltungsteile nach der anschließenden Inbetriebnahme normale Betriebsaufgaben der Schaltungseinheit (CU) wahrnehmen können.

3. Elektrische Schaltungseinheit (integrierte Schaltung, Modul, Gerät), die zumindest teilweise als elektrisch umkonfigurierbare Schaltung ausgeführt ist, **dadurch gekennzeichnet, daß** die Schaltungseinheit (CU) so ausgebildet ist und zumindest ein Teil der als elektrisch umkonfigurierbare Schaltung ausgeführten Schaltungsteile derart konfigurierbar ist, daß von dem zumindest einen Teil der als elektrisch umkonfigurierbare Schaltung ausgeführten Schaltungsteile sowohl Verbindungen zu einer Schnittstelle (IF3) zur Umgebung der Schaltungseinheit (CU) möglich sind als auch Testschleifen (TPll-TP12-TP13-TP14-TP15, TP21-TP22-TP23-TP24) innerhalb der Schaltungseinheit (CU).

4. Verfahren nach Anspruch 1, **dadurch gekennzeichnet, daß** die Umkonfigurierung über die Testschnittstelle (IF3) erfolgt.

5. Verfahren nach Anspruch 1, **dadurch gekennzeichnet, daß** die Umkonfigurierung der Schaltungsteile derart schrittweise erfolgt, daß die bereits umkonfigurierten Schaltungsteile durch die noch nicht umkonfigurierten Schaltungsteile in ihrer neuen Funktion geprüft werden können.
